(19) Europäisches Patentamt
European Patent Office
Office européen des brevets

(11) Veröffentlichungsnummer: **0 030 001**
**B1**

(12) # EUROPÄISCHE PATENTSCHRIFT

(45) Veröffentlichungstag der Patentschrift: **19.10.83**

(51) Int. Cl.³: **G 03 C 1/71**, G 03 C 1/54, G 03 F 7/08, G 03 F 7/26

(21) Anmeldenummer: **80107387.5**

(22) Anmeldetag: **26.11.80**

(54) **Lichtempfindliches Gemisch und damit hergestelltes lichtempfindliches Kopiermaterial.**

(30) Priorität: **03.12.79 DE 2948554**

(43) Veröffentlichungstag der Anmeldung: **10.06.81 Patentblatt 81/23**

(45) Bekanntmachung des Hinweises auf die Patenterteilung: **19.10.83 Patentblatt 83/42**

(84) Benannte Vertragsstaaten: **AT BE CH DE FR GB IT LI NL SE**

(56) Entgegenhaltungen: **keine**

(73) Patentinhaber: **HOECHST AKTIENGESELLSCHAFT, Postfach 80 03 20, D-6230 Frankfurt am Main 80 (DE)**

(72) Erfinder: **Neubauer, Rudolf, Dr. Dipl.-Chem., Goetheweg 3, D-6229 Erbach/Rheingau (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



BUNDESDRUCKEREI BERLIN

# Lichtempfindliches Gemisch und damit hergestelltes lichtempfindliches Kopiermaterial

Die Erfindung betrifft ein negativ arbeitendes lichtempfindliches Gemisch, das als lichtempfindliche Verbindung ein Diazoniumsalz-Polykondensationsprodukt und als Bindemittel ein Polyurethanharz enthält, das keine endständige Isocyanatgruppen aufweist, und vorzugsweise zur Herstellung von Druckplatten verwendet wird.

Gemische der angegebenen Gattung sind in der US-A-3 660 097 beschrieben. Dort werden lineare Polyurethanharze in Kombination mit negativ oder positiv arbeitenden Diazoverbindungen beschrieben. Die dort beschriebenen Gemische und die damit hergestellten lichtempfindlichen Kopiermaterialien haben bestimmte Nachteile. Sie sind in üblichen Beschichtungslösungsmitteln, wie Glykolmonoäthern, relativ schlecht löslich, die Lösung muß zur Entfernung von Rückständen mehrfach filtriert werden. Die Schichten lassen sich schwierig entwickeln, und die erzielbare Druckauflage ist begrenzt.

Aus der DE-A-2 739 774 sind entsprechende Gemische und Kopiermaterialien bekannt, die Polyurethane mit endständigen NCO-Gruppen in Kombination mit Säure als Stabilisator enthalten. Diese Materialien haben eine wesentlich bessere Löslichkeit und ergeben höhere Druckauflagen. Ihre Entwickelbarkeit ist ebenfalls verbessert, aber noch nicht optimal.

Aus der DE-A-2 361 931 sind photopolymerisierbare, eine Diazoniumverbindung enthaltende Gemische bekannt, die verzweigte Polyurethanharze mit endständigen, von Dihydroxyverbindungen abgeleiteten Einheiten enthalten können.

Aufgabe der Erfindung war es, lichtempfindliche Gemische der angegebenen Gattung vorzuschlagen, die leichter und sicherer mit umweltfreundlichen Entwicklern entwickelbar sind als die bekannten Gemische.

Gegenstand der Erfindung ist ein lichtempfindliches Gemisch, das als lichtempfindliche Verbindung ein Diazoniumsalz-Polykondensationsprodukt und als Bindemittel ein Polyurethanharz enthält, das keine endständigen Isocyanatgruppen aufweist.

Das erfindungsgemäße Gemisch ist dadurch gekennzeichnet, daß das Polyurethanharz ein verzweigtes Polyurethan ist, dessen endständige Einheiten mindestens teilweise von Dihydroxyverbindungen abgeleitet sind.

Die in den erfindungsgemäßen Gemischen enthaltenen verzweigten Polyurethane sind Polyadditionsprodukte aus Vervindungen mit zwei oder mehreren Isocyanatgruppen und Verbindungen mit zwei oder mehreren aktiven, gegenüber Isocyanatgruppen reaktionsfähigen Wasserstoffatomen. Mindestens ein Teil der Verbindungen mit reaktionsfähigen Wasserstoffatomen sind Dihydroxyverbindungen. Die Reaktionspartner werden in solchen Mengen eingesetzt, daß alle Isocyanatgruppen umgesetzt werden. Alle Endgruppen weisen deshalb aktive Wasserstoffatome auf, wobei mindestens ein Teil der endständigen Einheiten jeweils eine freie Hydroxygruppe hat.

Durch Verwendung eines geeigneten Anteils von tri- oder höherfunktionellen Verbindungen werden Verzweigungsstellen in gewünschter Menge in das Polymermolekül eingeführt. Trifunktionelle Verbindungen werden für diesen Zweck bevorzugt, insbesondere dreiwertige Alkohole.

Allgemein werden als Verbindungen mit reaktionsfähigen Wasserstoffatomen (H-aktive Verbindungen) Hydroxyverbindungen, insbesondere aliphatische Diole und Triole bevorzugt.

Als geeignete Diisocyanate kommen in Betracht:

2,4-Tolylendiisocyanat; 2,6-Tolylendiisocyanat; 4,4'-Diphenylmethan-diisocyanat; Isophorondiisocyanat; 2,2,4-Trimethyl-hexamethylendiisocyanat, Hexamethylendiisocyanat; Xylylendiisocyanat; 3,3'-Bitolylen-4,4'-diisocyanat; 3,3'-Dimethyl-cyclohexan-4,4'-diisocyanat; Benzylcyclohexan-4,4'-diisocyanat; 4,4'-Diphenylätherdiisocyanat; Naphthalindiisocyanat; Lysin-diisocyanat.

Bevorzugt werden

2,4-Tolylendiisocyanat, 2,6-Tolylendiisocyanat, 4,4'-Diphenylmethan-diisocyanat und 2,2,4-Trimethyl-hexamethylen-diisocyanat.

Die Diisocyanate können allein oder in Mischungen miteinander verwendet werden.

Ein Teil der Diisocyanatmenge kann auch durch tri- und höherfunktionelle Polyisocyanate ersetzt werden, z. B. durch Triphenylmethan-4,4',4''-triisocyanat, ein Biuretgruppen enthaltendes Triisocyanat, hergestellt aus 1 Mol Wasser und 3 Mol Hexamethylendiisocyanat, und Mischungen dieser Verbindungen.

Als dreiwertige Alkohole können z. B. 1,1,1-Trimethylolmethan, 1,1,1-Trimethylol-äthan, 1,1,1-Trimethylolpropan, Glycerin, Triäthanolamin, Trishydroxyäthylisocyanurat und Tris-hydroxyäthyl-phloroglucin verwendet werden.

Bevorzugt werden die 1,1,1-Trimethylol-alkane.

Als zweiwertige Hydroxyverbindungen eignen sich unter anderem Polyalkylenglykole der

allgemeinen Formel

$$HO(-CHR-C_mH_{2m}-O)_n-H,$$

worin

R = H oder Alkyl, vorzugsweise H oder Methyl,
m eine ganze Zahl von 1 bis 10 und
n eine ganze Zahl von 2 bis 10 ist.

Weiterhin können Polyesterdiole und Polybutadiendiole eingesetzt werden.

Außerdem können Diole verwendet werden, die aromatische Ringe oder Heteroatome enthalten, wie in folgenden allgemeinen Formeln:

$$HO-C_kH_{2k}-Ar-C_sH_{2s}-OH$$

$$HO-C_kH_{2k}-(X-C_sH_{2s})_i-OH$$

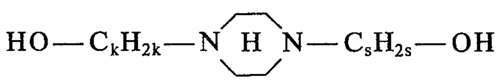

wobei

Ar ein Arylen- vorzugsweise Phenylenrest ist,
X NH, S oder O sein kann und
k und s ganze Zahlen von 1 bis 6 sind

oder z. B. 2,2-Bis(4-$\beta$-hydroxyäthoxy-phenyl)propan oder Hydroxypivalinsäure-neopentylglykolester. Aliphatische Diole werden bevorzugt.

Weiterhin können Verbindungen mit zwei oder mehreren aktiven Wasserstoffatomen der allgemeinen Formel

$$HX-R'-YH,$$

einen Teil des Diols bzw. Triols ersetzen, wobei

X und Y gleich oder verschieden sind und O, NR'' oder S,
R' einen aliphatischen, aromatischen, gemischt aliphatisch-aromatischen oder heterocyclischen Rest und
R'' H, einen Alkylrest oder einen Rest R'—XH

bedeuten.

R' kann z. B. Phenylen, Pyridylen, $C_nH_{2n}$, $C_nH_{2n}$-Phenylen oder $C_nH_{2n}$-Phenylen-$C_nH_{2n}$ sein.

Beispiele für geeignete Verbindungen der Formel HX—R'—YH sind Äthylendiamin, Thioglykol, Diäthanolamin, Butanolamin, Diäthylentriamin und m-Aminophenol.

Von zwei verschiedenen oder nicht symmetrischen gegenüber Isocyanaten reaktiven Gruppen reagiert unter den Reaktionsbedingungen im allgemeinen eine der Gruppen bevorzugt.

Weiterhin können auch Verbindungen verwendet werden, die nur eine unter den Reaktionsbedingungen gegenüber Isocyanaten reaktive Gruppierung haben, jedoch weitere funktionelle Gruppen aufweisen können. Beispiele für solche Verbindungen sind 2-Amino-pyridin, N,N-Dimethyl-äthanolamin, N-Äthyl-N-(2-hydroxyäthyl)-anilin und N,N-Diäthyl-m-aminophenol. Diese Verbindungen machen jeweils nur einen kleineren Mengenanteil aller H-aktiven Verbindungen aus.

Die Mengenverhältnisse von trifunktionellen zu difunktionellen Verbindungen sowie der stöchiometrische Überschuß an H-aktiven Verbindungen werden im einzelnen nach dem gewünschten Grad der Verzweigung und dem gewünschten Molekulargewicht gewählt. Durch diese Parameter werden die Eigenschaften, insbesondere die Entwickelbarkeit der mit diesen Bindemitteln hergestellten lichtempfindlichen Schichten, d. h. die Löslichkeit oder Emulgierbarkeit des Bindemittels im verwendeten Entwickler, bestimmt. Wenn als H-aktive Verbindungen ausschließlich Hydroxyverbindungen verwendet werden, beträgt das Verhältnis Diol zu Triol gewöhnlich 0,1 bis 9, bevorzugt 1 bis 4 Mol je Mol Triol.

Das Molverhältnis von Isocyanatverbindung zu H-aktiver Verbindung bestimmt das zu erwartende Molekulargewicht. Es wird so abgestimmt, daß keine zu hohen Molekulargewichte entstehen, da sich dies nachteilig auf die Entwickelbarkeit der Schicht auswirken würde. Die durch Gelpermeationschromatographie bestimmbare Molgewichtsverteilung sollte keine nennenswerten Anteile über 200 000 enthalten.

Die mittleren Molekulargewichte der verzweigten Polyurethane können je nach dem Verzweigungsgrad und der Natur der Bestandteile innerhalb weiter Grenzen variieren. Im allgemeinen sind solche Produkte gut geeignet, deren häufigste Molekulargewichte (Maxima der Molekulargewichtsverteilungskurven) zwischen 3000 und 30 000 liegen. Produkte mit Werten zwischen 5000 und 20 000 werden bevorzugt.

Der Verzweigungsgrad der Polymermoleküle sollte im allgemeinen so bemessen sein, daß auf jeweils 650 bis 10 000, vorzugsweise 750 bis 5000 Molekulargewichtseinheiten eine Verzweigungsstelle kommt. Dabei sind die niedrigeren Werte innerhalb dieser Bereiche Polymeren mit niedrigeren mittleren Molekulargewichten zuzuordnen und umgekehrt.

Die verzweigten Polyurethane werden in bekannter Weise durch Umsetzen von Isocyanatverbindungen mit H-aktiven Verbindungen, insbesondere Hydroxyverbindungen in einem inerten Lösungsmittel, zweckmäßig in Gegenwart eines Katalysators, z. B. eines tertiären Amins, bei erhöhter Temperatur hergestellt. Dabei können alle Reaktionsteilnehmer gleichzeitig umgesetzt werden (Eintopfverfahren). Es kann aber auch in einer ersten Stufe ein verzweigtes, endständige Isocyanatgruppen enthaltendes Präpolymeres hergestellt werden, dessen Endgruppen dann mit einem Überschuß an H-aktiver Verbindung umgesetzt werden, wovon mindestens ein Teil aus Diol besteht.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatische Aminen, Phenolen, Phenoläthern, aromatischen Thioäthern, aromatischen Kohlenwasserstoffen, aromatischen Heterocyclen und organischen Säureamiden, abgeleitet sind. Diese Kondensationsprodukte sind in der DE-A-2 024 244 beschrieben. Allgemein sind alle Diazoniumsalz-Polykondensationsprodukte geeignet, die in der DE DE-A-2 739 774 beschrieben sind.

Die Diazoniumsalzeinheiten leiten sich bevorzugt von Verbindungen der Formel $(R^1-R^3-)_pR^2-N_2X$ ab, wobei

X das Anion der Diazoniumverbindung,
p eine ganze Zahl von 1 bis 3,
$R^1$ einen aromatischen Rest mit mindestens einer zur Kondensation mit aktiver Carbonylverbindung befähigten Position,
$R^2$ eine Phenylengruppe,
$R^3$ eine Einfachbindung oder eine der Gruppen:

$$-(CH_2)_q-NR^4-$$

$$-O-(CH_2)_r-NR^4-$$

$$-S(CH_2)_r-NR^4-$$

$$-S-CH_2CO-NR^4-$$

$$-O-R^5-O-$$

$$-O-$$

$-S-$ oder

$$-CO-NR^4-$$

bedeuten, worin

q eine Zahl von 0 bis 5,
r eine Zahl von 2 bis 5,
$R^4$ Wasserstoff, eine Alkylgruppe mit 1—5 C-Atomen, eine Aralkylgruppe mit 7—12 C-Atomen oder eine Arylgruppe mit 6—12 C-Atomen, und
$R^5$ eine Arylengruppe mit 6—12 C-Atomen ist.

Die erfindungsgemäßen Gemische enthalten das Diazoniumsalz-Polykondensationsprodukt und das verzweigte Polyurethan im allgemeinen in Mengen von 10 bis 90, bevorzugt 10 bis 70 Gew.-% Diazoniumverbindung und 90 bis 10, bevorzugt 90 bis 30 Gew.-% Polyurethan.

Zur Stabilisierung des lichtempfindlichen Gemischs ist es vorteilhaft, diesem eine Verbindung mit Säurecharakter zuzusetzen. In Betracht kommen Mineralsäuren und starke organische Säuren, von denen Phosphorsäure, Schwetelsäure, Perchlorsäure, Borsäure oder p-Toluolsulfonsäure bevorzugt

werden. Eine besonders gut geeignete Säure ist die Phosphorsäure.

Den Gemischen können ferner bekannte Weichmacher, Haftvermittler, Farbstoffe, Pigmente, Farbbildner und andere Harze zugesetzt werden.

Art und Menge dieser Zusätze richten sich nach dem für das erfindungsgemäße Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die lichtempfindlichen Gemische können ferner Farbstoffe und/oder Pigmente enthalten, die sowohl als Kontrastmittel als auch schichtverfestigend wirken können. In Frage kommende Farbstoffe sind beispielweise in den US-Patentschriften 3 218 167 und 3 884 693 angegeben.

Besonders geeignet ist z. B. Viktoriaeinblau FGA oder Zaponechtfeuerrot B (C. I. 13900 : 1).

Zur Erhöhung des Bildkontrastes nach der Belichtung können Metanilgelb (C. I. 13065) und Methylorange (C. I. 13025) verwendet werden.

Im Rahmen der Erfindung wird folgende gewichtsmäßige Verteilung der wichtigsten Bestandteile in dem lichtempfindlichen Gemisch bevorzugt, bezogen auf den Gehalt an nichtflüchtigen Bestandteilen, d. h. die Bestandteile der nach dem Verdampfer des Lösungsmittels erhaltenen festen lichtempfindlichen Schicht.

| | |
|---|---|
| Polyurethan: | 30 bis 90% |
| Diazoniumsalz-Polykondensationsprodukt: | 10 bis 70% |
| Säure: | 0 bis 5% |
| Farbstoff oder Pigment: | 0 bis 5% |
| Belichtungskontrastgeber (Farbstoff): | 0 bis 5% |

Die erfindungsgemäßen lichtempfindlichen Gemische können gewerblich in Form einer Lösung oder Dispersion, z. B. als sogenannter Kopierlack, verwertet werden, die vom Verbraucher selbst auf einen individuellen Träger, wie beispielsweise für das Formteilätzen, für die Herstellung kopierter Schaltungen bzw. Schablonen, Beschilderungen, Siebdruckformen und dgl. gebräuchlich, aufgebracht und nach dem Trocknen belichtet und bildmäßig entwickelt werden. In diesem Falle werden die Bestandteile des lichtempfindlichen Gemischs in einem geeigneten Lösungsmittel gelöst. Als Lösungsmittel sind Alkohole, Ketone, Ester und Äther und dgl. geeignet. Als günstige Lösungsmittel haben sich dabei die Partialäther der Glykole oder der Ketoalkohole erwiesen, z. B. Äthylenglykolmonomethyläther.

Das erfindungsgemäße lichtempfindliche Gemisch kann insbesondere aber auch in Form einer festen, auf einem Trägermaterial befindlichen, lichtempfindlichen Schicht für die Herstellung von Druckformen, Reliefbildern, Ätzreserven, Schablonen, Matern, Siebdruckformen, Einzelkopien und dgl. in den Handel gebracht werden. Eine besonders wichtige Anwendung bilden lagerfähige vorsensibilisierte Druckplatten für den Flachdruck.

Die Beschichtung des Trägermaterials erfolgt aus entsprechenden organischen Lösungsmitteln oder Lösungsmittelgemischen, und zwar durch Gießen, Sprühen oder Eintauchen.

Als Schichtträger eignen sich z. B. Magnesium, Zink, Kupfer, mechanisch, chemisch und elektrochemisch aufgerauhtes Aluminium, anodisiertes Aluminium, Stahl, aber auch Polyester- oder Acetatfolie, Perlongaze etc., deren Oberfläche bei Bedarf einer Vorbehandlung unterworfen sein kann. Das Trägermaterial kann dabei als endgültiger Schichtträger fungieren oder als intermediäres Trägermaterial, von dem die lichtempfindliche Schicht auf das zu bearbeitende Werkstück mittels Laminieren aufgebracht wird.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden.

Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UV-härtbaren Druckfarben.

Besonders bevorzugt wird das Gemisch zur Herstellung von Flachdruckformen verwendet, wobei als Trägermaterial Aluminium bevorzugt wird.

Besonders bevorzugt wird Aluminium, das für diesen Zweck in üblicher Weise vorbehandelt wird, z. B. durch mechanisches, chemisches oder elektrochemisches Aufrauhen und ggf. anschließende anodische Oxidation. Eine weitere Behandlung dieses Trägermaterials, z. B. mit Polyvinylphosphonsäure, Alkalisilikat, Phosphat, Hexafluorzirkonat, Chromat, Borat, Polyacrylamid und Cellulosederivaten, ist vorteilhaft.

Die Verarbeitung der aus den Gemischen erhaltenen Kopiermaterialien erfolgt in bekannter Weise durch bildmäßiges Belichten und Auswaschen der unbelichteten Schichtbereiche mit einem geeigneten Entwickler. Als Entwickler werden bevorzugt wäßrige Lösungen verwendet, die mindestens 80 Gew.-% Wasser enthalten. Geeignete Entwicklerlösungen sind z. B. in den DE-A-2 809 774 und 2 941 960 beschrieben.

Durch die Erfindung wird das aus der US-A-3 660 097 bekannte Vorurteil überwunden, wonach nur

lineare thermoplastische Polyurethane als Bindemittel in lichtempfindlichen Schichten von Druckplatten geeignet seien.

Es ist überraschend, daß verzweigte Polyurethane enthaltende Gemische des erfindungsgemäß vorgeschlagenen Typs nicht nur in den zur Beschichtung in Frage kommenden Lösungsmittels leicht löslich, sondern auch mit umweltfreundlichen wäßrigen Entwicklern entwickelbar sind und damit den linearen Polyurethanen, wie sie in der US-A-3 660 097 beschrieben werden, überlegen sind.

Nach dem Entwickeln können die Materialien unmittelbar verwendet werden, z B. als Flachdruckformen. Sie können auch in bekannter Weise einer Wärmebehandlung von einigen Minuten bei etwa 200—240° C unterworfen werden, um die Druckauflage zu erhöhen.

Die verzweigte Polyurethane enthaltenden Schichten zeigen folgende Vorteile:

Sie besitzen hohe praktische Lichtempfindlichkeit, scharfe Differenzierungsmöglichkeiten zwischen Bild- und Nichtbildstellen, hohes Auflösungsvermögen, leichte schleierfreie Aufentwicklung, hohe Druckauflagen, gute Verträglichkeit der Schichtbestandteile in den zur Beschichtung geeigneten Lösungsmitteln, z. B. Äthylenglykolmonomethyläther, Äthylenglykolmonoäthyläther, Diacetonalkohol, sowie Gemische der genannten Lösungsmittel mit Butylacetat, Äthylenglykolmethylätheracetat und Methylisobutylketon.

Die folgenden Beispiele sollen die Erfindung erläutern. Gewichtsteile und Volumenteile stehen im Verhältnis von g/ccm, Prozentangaben und Mengenverhältnisse sind in Gewichtseinheiten zu verstehen, wenn nichts anderes angegeben ist.

## Beispiel 1

Eine Mischung aus 91,5 g (0,125 Mol) eines Präpolymeren, hergestellt aus Tolylendiisocyanat und 1,1,1-Trimethylol-propan im Molverhältnis 3 : 1, 36,2 g (0,306 Mol) Hexandiol-1,6 und 0,1 g 1,4-Diazabicyclo [2.2.2]-octan in 650 ml Tetrahydrofuran wurde 10 Stunden zum Rückfluß erhitzt.

Nach dem Abkühlen betrug die Viskosität der Lösung bei 25° C 0,291 $cm^2/s$. Die Lösung wurde in 5 Liter Wasser einfließen gelassen und das erhaltene weiße körnige Produkt abfiltriert und getrocknet. Die Ausbeute betrug 120 g Polymere mit einem Erweichungspunkt von ca. 110° C.

Eine Beschichtungslösung wurde aus

30,0 Gt des oben beschriebenen Bindemittels,
15,6 Gt eines Diazoniumsalz-Polykondensationsprodukts, hergestellt aus Paraformaldehyd und Diphenylamin-4-diazoniumchlorid in 85%iger Phosphorsäure,
15,0 Gt einer Pigmentdispersion, bestehend aus 10% β-Kupferphthalocyaninpigment (C. I. 74160), 10% Polyvinylformal und 80% Essigsäure-2-methoxy-äthyl-ester,
0,4 Gt Metanilgelb (C. I. 13065) und
1,0 Gt Phosphorsäure (85%) in
940,0 Gt Äthylenglykolmonomethyläther

hergestellt.

Die Lösung wurde auf eine Aluminiumfolie, die durch Bürsten mit einer wäßrigen Schleifmittelsuspension aufgerauht und danach mit einer wäßrigen Lösung von Polyvinylphosphonsäure vorbehandelt worden war, aufgebracht.

Die Kopierschicht wurde unter einer Negativvorlage 30 Sekunden lang mit einer Metallhalogenid-Lampe von 5 kW Leistung belichtet.

Die belichtete Schicht wurde mit einer Entwicklerlösung folgender Zusammensetzung

5,0 Gt Benzylalkohol,
5,0 Gt eines Mischpolymerisats aus N-Methyl-N-Vinylacetamid und Dioctylmaleinat (88 : 12),
3,0 Gt Na-Octylsulfat,
4,0 Gt Phosphorsäure (85%)

mittels Plüschtampons behandelt, wobei die Nichtbildstellen entfernt wurden, mit Wasser abgespült und abgerakelt. In der Kopie war die Stufe 5 eines Silberfilm-Halbtonstufenkeils mit dem Dichteumfang 0,05 bis 3,05, wobei die Dichteinkremente 0,15 betrugen, noch voll geschwärzt.

Die erhaltenen Druckplatte lieferte an einer Bogenoffsetmaschine eine Auflage von 40 000 Bögen.

## Beispiel 2

Eine Beschichtungslösung wurde aus

34,5 Gt des in Beispiel 1 beschriebenen Polyurethans,
11,5 Gt eines Diazomischkondensats, hergestellt durch Kondensieren von 1 Mol 3-Methoxy-diphenylamin-4-diazoniumsulfat mit 1 Mol 4,4′-Bis-methoxymethyl-diphenyläther in 85%iger Phosphorsäure und Isolieren als Mesitylensulfonat und
2,0 Gt Phosphorsäure (85%) in
952,1 Gt Äthylenglykolmonomethyläther

bereitet.

Der Lösung wurde auf eine elektrochemisch aufgerauhte und anodisierte Aluminiumfolie, die mit Polyvinylphosphonsäure nachbehandelt worden war, aufgebracht. Das Schichtgewicht der lichtempfindlichen Schicht betrug nach dem Trocknen 1,0 $g/m^2$.

Die Verarbeitung wurde, wie in Beispiel 1 beschrieben, durchgeführt. Dabei wird die Offsetplatte nach bildmäßiger Belichtung für eine Minute in den Entwickler getaucht und anschließend mit Wasser abgebraust. Die Schicht ist einwandfrei entwickelt, d. h. daß auch sehr kleine Raster- und Strichelemente scharf differenziert abgebildet sind, keine Schlier oder Schichtreste auf Nichtbildstellen vorhanden sind und eine hohe Auflösung erreicht wird.

Zum Vergleich wird eine Offsetplatte wie oben beschrieben hergestellt, jedoch mit der gleichen Menge eines linearen Polyurethans aus 4,4′-Diphenylmethandiisocyanat und einem Überschuß eines Polyesterdiols aus Adipinsäure und Butandiol-1,4 anstelle des verzweigten Polyurethans.

Bei der Vergleichsplatte ist bei identischer Behandlung die Entwicklung unvollständig, Schichtreste und Schleier sind auf Nichtbildstellen deutlich vorhanden, schlechte Differenzierung zwischen Bild- und Nichtbildstellen und eine geringe Auflösung sind festzustellen.

## Beispiel 3

Eine Mischung von 19,80 g (0,09 Mol) 2,2,4-Trimethylhexanethylendiisocyanat, 7,84 g (0,03 Mol) Tris-(hydroxyäthyl)-isocyanurat, 14,16 g (0,07 Mol) Dodecandiol-1,12 und 0,1 g Dibutylzinndiacetat in 350 g Tetrahydrofuran wurde 4 Stunden zum Rückfluß erhitzt. Die Viskosität der Lösung betrug danach bei 25° C 0,022 $cm^2/s$.

Eine Beschichtungslösung wurde aus

23,0 Gt der oben erhaltenen Reaktionslösung,
2,3 Gt der in Beispiel 2 angegebenen Diazoniumverbindung,
0,2 Gt Viktoriablau B (C. I. 44045),
0,1 Gt Methylorange (C. I. 13025) und
0,1 Gt Phosphorsäure (85%) in
64,0 Gt Äthylenglykolmonomethyläther

hergestellt.

Die Lösung wurde auf den in Beispiel 2 angegebenen Schichtträger aufgebracht. Das Trockenschichtgewicht betrug 0,9 $g/m^2$.

Die Verarbeitung wurde, wie in Beispiel 1 beschrieben, durchgeführt. Mit der so erhaltenen Druckform wurden an einer Bogenoffsetmaschine hohe Auflagen erzielt.

## Beispiel 4

Eine Mischung aus 22,5 g (0,09 Mol) 4,4′-Diphenylmethandiisocyanat, 4,5 g (0,03 Mol) Triäthanolamin, 12,2 g (0,07 Mol) Decandiol-1,10 und 0,1 g 1,4-Diazabicyclo-[2.2.2]octan in 350 g Tetrahydrofuran wurde 4 Stunden zum Rückfluß erhitzt. Danach betrug die Viskosität der Lösung bei 25° C 0,035 $cm^2/s$.

Eine Beschichtungslösung wurde aus

20,0 Gt der obigen Reaktionslösung,
2,3 Gt der in Beispiel 2 angegebenen Diazoniumverbindung,
0,2 Gt Rhodamin FB (C. I. 45170),
0,1 Gt Metanilgelb (C. I. 13065) und
0,1 Gt Phosphorsäure (85%) in
67,0 Gt Äthylenglykolmonomethyläther

hergestellt.

Die Lösung wurde auf den in Beispiel 2 beschriebenen Schichtträger derart aufgetragen, daß nach dem Trocknen ein Schichtgewicht von 1,0 $g/m^2$ erhalten wurde. Die Verarbeitung wurde wie in Beispiel 1 beschrieben, durchgeführt. An Bogenoffsetmaschinen wurden mit dieser Druckform hohe Auflagen erzielt.

Beispiel 5

Eine Mischung aus 15,98 g (0,095 Mol) Hexamethylendiisocyanat, 5,97 g (0,04 Mol) Triäthanolamin, 8,65 g (0,06 Mol) 1,4-Bis-(hydroxymethyl)-cyclohexan, 0,1 g Di-n-butylzinndiacetat und 250 g Tetrahydrofuran wurde 4 Stunden zum Rückfluß erhitzt. Danach betrug die Viskosität der Lösung bei 25° C 0,0212 $cm^2/s$.

Eine Beschichtungslösung wurde aus

34,0 Gt der obigen Reaktionslösung,
1,2 Gt der in Beispiel 2 angegebenen Diazoniumverbindung,
0,2 Gt Fettrot 5 B (C. I. 26125),
0,1 Gt Metanilgelb und
0,1 Gt Phosphorsäure (85%) in
64,0 Gt Äthylenglykolmonomethyläther

hergestellt.

Die Lösung wurde auf den in Beispiel 2 beschriebenen Träger derart aufgetragen, daß nach dem Trocknen ein Schichtgewicht von 1,0 $g/m^2$ erhalten wurde. Die Verarbeitung wurde, wie in Beispiel 1 beschrieben, durchgeführt. An Bogenoffsetmaschinen wurden mit dieser Druckform gute Auflagen erhalten.

Beispiel 6

Eine Mischung aus 11,52 g (0,02 Mol) eines Biuretgruppen enthaltenden Triisocyanats, hergestellt durch Umsetzung von Hexamethylendiisocyanat mit Wasser im Molverhältnis 3 : 1, 10,0 g (0,05 Mol) Polyäthylenglykol mit einem mittleren Molekulargewicht von 200, 0,1 g Dioctylzinndilaurat und 190 g Tetrahydrofuran wurde eine Stunde zum Rückfluß erhitzt. Danach besaß die Lösung eine Viskosität von 0,0172 $cm^2/s$ bei 25° C.

Eine Beschichtungslösung wurde hergestellt aus

34,5 Gt der obigen Reaktionslösung,
1,15 Gt der in Beispiel 2 angegebenen Diazoniumverbindung,
0,2 Gt Viktoriaeinblau FGA (C. I. Basic Blue 81),
0,1 Gt Metanilgelb und
0,1 Gt Phosphorsäure (85%) in
64,0 Gt Äthylenglykolmonomethyläther.

Die Lösung wurde auf den in Beispiel 2 beschriebenen Träger derart aufgetragen, daß nach dem Trocknen ein Schichtgewicht von 1,0 $g/m^2$ erhalten wurde.

Die Verarbeitung wurde ähnlich wie in Beispiel 1 durchgeführt. An Bogenoffsetmaschinen wurden mit derartigen Druckformen hohe Auflagen erhalten.

Beispiel 7

Eine Lösung von 26,8 g (0,2 Mol) 1,1,1-Trimethylolpropan, 70,9 g (0,6 Mol) Hexandiol-1,6, 159,3 g (0,09 Mol) Tolylendiisocyanat und 0,1 g Triäthylamin in 1000 g Tetrahydrofuran wurde 5 Stunden zum Rückfluß erhitzt. Danach hatte die Lösung eine Viskosität von 0,0379 $cm^2/s$ bei 25° C.

Eine Beschichtungslösung wurde hergestellt aus

17,25 Gt der obigen Reaktionslösung,
1,15 Gt der in Beispiel 2 angegebenen Diazoniumverbindung,
0,2 Gt Rhodamin FB,
0,1 Gt Metanilgelb und
0,1 Gt Phosphorsäure (85%) in
64,0 Gt Äthylenglykolmonomethyläther.

Die Lösung wurde auf einen elektrochemisch aufgerauhten und anodisierten Träger derart aufgetragen, daß nach dem Trocknen ein Schichtgewicht von 1,0 $g/m^2$ erhalten wurde.

Die Verarbeitung wurde ähnlich wie in Beispiel 1 beschrieben durchgeführt. Die erhaltene Druckform ergab an Bogenoffsetmaschinen Auflagen von mehr als 50 000 Drucken.

## Patentansprüche

1. Lichtempfindliches Gemisch, das als lichtempfindliche Verbindung ein Diazoniumsalz-Polykondensationsprodukt und als Bindemittel ein Polyurethanharz enthält, das keine endständigen Isocyanatgruppen aufweist, dadurch gekennzeichnet, daß das Polyurethanharz ein verzweigtes Polyurethan ist, dessen endständige Einheiten mindestens teilweise von Dihydroxyverbindungen abgeleitet sind.
2. Lichtempfindliches Gemisch nach Anspruch 1, dadurch gekennzeichnet, daß das verzweigte Polyurethan im Mittel eine Verzweigungsstelle je 650 bis 10 000 Molekulargewichtseinheiten enthält.
3. Lichtempfindliches Gemisch nach Anspruch 1, dadurch gekennzeichnet, daß das verzweigte Polyurethan ein Polyadditionsprodukt aus einem Diisocyanat, einem Diol und einem Triol ist.
4. Lichtempfindliches Gemisch nach Anspruch 3, dadurch gekennzeichnet, daß das Polyurethan im Mittel 0,1 bis 9 Dioleinheiten je Trioleinheit enthält.
5. Lichtempfindliches Gemisch nach Anspruch 1, dadurch gekennzeichnet, daß es 30 bis 90 Gew.-% Polyurethan und 10 bis 70 Gew.-% Diazoniumsalz-Polykondensationsprodukt enthält.
6. Lichtempfindliches Gemisch nach Anspruch 1, dadurch gekennzeichnet, daß das Polyurethan ein häufigstes Molekulargewicht von 3000 bis 30 000 hat.
7. Lichtempfindliches Gemisch nach Anspruch 1, dadurch gekennzeichnet, daß das Diazoniumsalz-Polykondensationsprodukt aus wiederkehrenden Einheiten $A-N_2X$ und B besteht, die durch Zwischenglieder, vorzugsweise Methylengruppen, verbunden sind, die von kondensationsfähigen Carbonylverbindungen, vorzugsweise Formaldehyd, abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenoläthers, aromatischen Thioäthers, aromatischen Kohlenwasserstoffs, aromatischen Heterocyclus oder eines organischen Säureamids ist.
8. Lichtempfindliches Kopiermaterial für die Herstellung von Druckplatten, bestehend aus einem Schichtträger und einer negativ arbeitenden lichtempfindlichen Schicht, die ein Diazoniumsalz-Polykondensationsprodukt und ein Polyurethanharz enthält, das keine endständigen Isocyanatgruppen aufweist, dadurch gekennzeichnet, daß das Polyurethanharz ein verzweigtes Polyurethan ist, dessen endständige Einheiten mindestens teilweise von Dihydroxyverbindungen abgeleitet sind.
9. Lichtempfindliches Kopiermaterial nach Anspruch 8, dadurch gekennzeichnet, daß der Schichtträger aus anodisch oxydiertem Aluminium besteht.

## Claims

1. A light-sensitive composition which comprises as the light, sensitive compound a diazonium salt polycondensation product and as the binding agent a polyurethane resin which does not contain any terminal isocyanate groups, the composition being characterized in that the polyurethane resin is a branched polyurethane the terminal units of which are at least partially derived from dihydroxy compounds.
2. A light-sensitive composition as claimed in claim 1, wherein the branched polyurethane has, on an average, one branching point for every 650 to 10,000 molecular weight units.
3. A light-sensitive composition as claimed in claim 1, wherein the branched polyurethane is a polyaddition product from a diisocyanate, a diol and a triol.
4. A light-sensitive composition as claimed in claim 3, wherein the polyurethane contains, on an average, 0.1 to 9 diol units for each triol unit.
5. A light-sensitive composition as claimed in claim 1, which comprises from 30 to 90 percent by weight of polyurethane and from 10 to 70 percent by weight of diazonium salt polycondensation product.
6. A light-sensitive composition as claimed in claim 1, wherein the most frequent molecular weight of the polyurethane ranges from 3,000 to 30,000.
7. A light-sensitive composition as claimed in claim 1, wherein the diazonium salt polycondensation product comprises recurring units $A-N_2X$ and B connected by intermediate members, preferably methylene groups, which are derived from carbonyl compounds capable of condensation preferably formaldehyde, A being a radical of an aromatic diazonium compound which is capable of condensation with formaldehyde and B being a radical of a compound which is free from diazonium groups and is capable of condensation with formaldehyde, in particular of an aromatic amine, a phenol, a phenol ether, an aromatic thioether, an aromatic hydrocarbon, an aromatic heterocycle or an organic acid amide.
8. A light-sensitive copying material für the preparation of printing plates, comprising a layer support and a negativeacting light-sensitive layer which contains a diazonium salt polycondensation product and a polyurethane resin which does not contain any terminal isocyanate groups, characterized in that the polyurethane resin is a branched polyurethane the terminal units of which are at least partially derived from dihydroxy compounds.

9. A light-sensitive copying material as claimed in claim 8, wherein the layer support comprises anodically oxidized aluminum.

**Revendications**

1. Mélange sensible à la lumière contenant comme composé sensible à la lumière un produit de polycondensation d'un sel de diazonium et comme liant une résine de polyuréthanne, ne présentant aucun groupe isocyanate terminal, caractérisé en ce la résine de polyuréthanne est un polyuréthanne ramifié dont les unités terminales sont dérivées au moins en partie de composés dihydroxylés.

2. Mélange sensible à la lumière selon la revendication 1, caractérisé en ce que la polyuréthanne ramifié contient en moyenne un emplacement de ramification par 650 á 10.000 unités de poids moléculaire.

3. Mélange sensible à la lumière selon la revendication 1, caractérisé en ce que le polyuréthanne ramifié est un produit de polyaddition d'un diisocyanate, d'un diol et d'un triol.

4. Mélange sensible à la lumière selon la revendication 3, caractérisé en ce que le polyuréthanne contient en moyenne 0,1 à 9 unités de diol par unité de triol.

5. Mélange sensible à la lumière selon la revendication 1, caractérisé en ce qu'il contient 30 à 90% en poids de polyuréthanne et 10 à 70% en poids de produit de polycondensation d'un sel de diazonium.

6. Mélange sensible à la lumière selon la revendication 1, caractérisé en ce que le polyuréthanne a un poids moléculaire le plus souvent compris entre 3.000 et 30.000.

7. Mélange sensible à la lumière selon la revendication 1, caractérisé en ce que le produit de polycondensation de sel de diazonium est constitué d'unités $A-N_2X$ et B se répétant, reliées par des chaînons intermédiaires, de préférence par des groupes méthylène, dérivés de composés carbonylés condensables, de préférence le formaldéhyde, où A est le reste d'un composé de diazonium aromatique susceptible de se condenser avec le formaldéhyde et B est le reste d'un composé condensable avec le formaldéhyde dépourvu de groupes diazonium en particulier d'une amine aromatique, d'un phénol, d'un éther phénolique, d'un thioéther aromatique, d'un hydrocarbure aromatique, d'un hétérocycle aromatique ou d'un amide d'acide organique.

8. Matériau à copier sensible à la lumière pour la fabrication de plaques d'impression, constitué d'un support de couche et d'une couche sensible à la lumière travaillant négativement, contenant un produit de polycondensation d'un sel de diazonium et une résine de polyuréthanne ne présentant aucun groupe isocyanate terminal, caractérisé en ce la résine de polyuréthanne est un polyuréthanne ramifié dont les unités terminales sont dérivées au moins en partie de composés dihydroxylés.

9. Matériau à copier sensible à la lumière selon le revendication 8, caractérisé en ce que le support de couche est constitué par de l'aluminium oxydé anodiquement.